# EUROPÄISCHE PATENTANMELDUNG

(11) **EP 2 302 688 A1**
(43) Veröffentlichungstag der Anmeldung: **30.03.2011**
(21) Anmeldenummer: 09012122.9
(22) Anmeldetag: 23.09.2009
(51) Int. Cl.: H01L 31/0216

(54) **Verfahren zur Herstellung eines Substrats mit einer farbigen Interferenzfilterschicht, dieses Substrat, enthaltend eine farbige Interferenzfilterschicht, die Verwendung dieses Substrats als farbige Solarzelle oder als farbiges Solarmodul oder als Bestandteil hiervon sowie ein Array, umfassend mindestens zwei dieser Substrate**

(71) Anmelder: Robert Bosch GmbH, 70442 Stuttgart (DE)
(72) Erfinder: Probst, Volker, 14089 Berlin (DE); Thyen, Jan Rudolf, 14776 Brandenburg (DE); Hergert, Frank, 14776 Brandenburg (DE)

(57) **Zusammenfassung**

Die vorliegende Erfindung betrifft ein Verfahren zur Herstellung eines Substrats mit einer farbigen Interferenzfilterschicht, enthaltend polykristallines Metalloxid oder polykristalline Metalloxide, durch, insbesondere physikalische oder chemische, Gasphasenabscheidung mit einer Beschichtungsanlage, insbesondere mit Hilfe eines Sputtergases, bei dem man aus der Gasphase mindestens zwei, insbesondere mindestens sechs, Beschichtungslagen jeweils unter Ausbildung von polykristallinen Metalloxiden abscheidet mit einer durchschnittlichen Dicke der jeweiligen Beschichtungslagen im Bereich von etwa 50 nm bis 350 nm, insbesondere im Bereich von etwa 90 nm bis 210 nm, wobei die gemittelten atomaren Anteile mindestens eines, insbesondere jedes einzelnen, der in jeweils mindestens zwei, insbesondere sämtlichen, Beschichtungslagen, enthaltenen Metalle um nicht mehr als +/-20 Atom-%, vorzugsweise um nicht mehr als +/-10 Atom-% und besonders bevorzugt um nicht mehr als +/-5 Atom-%, von der gemittelten Zusammensetzung der Interferenzfilterschicht abweichen, wobei 100 Atom-% die Summe aller in der Schicht enthaltenen Metalle bezeichnet. Des weiteren betrifft die Erfindung ein nach diesem Verfahren erhältliches farbiges Substrat sowie ein Array, enthaltend eine Vielzahl an solchen Substraten.

## Beschreibung

Die vorliegende Erfindung betrifft ein Verfahren zur Herstellung eines Substrats mit einer farbigen Interferenzfilterschicht, dieses Substrat, enthaltend eine farbige Interferenzfilterschicht, die Verwendung dieses Substrats als farbige Solarzelle oder als farbiges Solarmodul oder als Bestandteil hiervon sowie ein Array, umfassend mindestens zwei dieser Substrate.

Aufgrund des absehbaren Versiegens herkömmlicher Energiequellen wie Öl und Kohle sowie des zunehmenden Treibhauseffektes als Folge klimaschädlicher Verbrennungsprodukte wie Kohlendioxid gewinnen so genannte regenerative Energiequellen stetig an Bedeutung. Hierzu zählen Sonnenkollektoren ebenso wie photovoltaische Solarmodule. Sowohl Sonnenkollektoren wie auch photovoltaische Solarmodule haben im Allgemeinen ein sehr dunkles optisches Erscheinungsbild. Allenfalls für kristalline Siliziumsolarmodule hält man bedingt durch das eingesetzte Silizium eine eher unregelmäßige Blauverfärbung. Diese Einschränkung führt bislang zu erheblichen Zugeständnissen bei der Anbringung solcher Solarmodule. Beispielsweise dürfen in Deutschland denkmalgeschützte Gebäude unter bestimmten Vorgaben nicht mit einer roten Dachziegelfläche nicht mit Solarmodulen versehen werden. Angesichts dieser Restriktionen hat es bislang nicht an Versuchen gefehlt, die Anwendungsbereiche von Solarmodulen zu erhöhen, um nicht mehr auf die technisch vorgegebene Farbe dieser Solarmodule angewiesen zu sein. Dieser Ansatz begegnet jedoch dem Problem, dass, um das Sonnenlicht effizient absorbieren und den höchstmöglichen Wirkungsgrad erreichen zu können, regelmäßig ein perfekt schwarzes Solarmodul angestrebt wird. Solche schwarzen Solarmodule erhält man zum Beispiel bei Dünnschichtsolarzellen auf der Basis von CIS-, CIGS- und CIGSSe-Absorbermaterialien. Farbige Solarmodule erhält man gegenwärtig nur auf folgende Art und Weise. So setzt man z. B. farbiges Glas ein für die äußere Glasscheibe, die regelmäßig als äußere Schutzlage gegen Verwitterung auf Solarmodulen aufliegt. Die Farbgebung solcher Gläser ist jedoch im reflektierten Licht sehr schwach. Auch muss zumeist ein starker Wirkungsgradverlust in Kauf genommen werden, da ein Großteil des einfallenden Lichts die lichtumwandelnde Absorberschicht des Solarmoduls nicht erreicht. Außerdem ist farbiges Flachglas kostenintensiv in der Herstellung. Alternativ hat man versucht, zwischen der äußeren Schutzglasschicht und der lichtumwandelnden Absorberschicht eine farbige Folie anzubringen. Die Farbwirkung solcher Systeme ist jedoch ähnlich schwach wie bei Verwendung einer eingefärbten Glasplatte. Erneut sind erhebliche Wirkungsgradeinbußen gegenüber herkömmlichen, Solarmodulen festzustellen. Als weitere Alternative wurde vorgeschlagen, das äußere Schutzglas mit einem farbigen Siebdruck zu versehen. Auch dieses Verfahren ist kostenintensiv und führt zu erheblichen Wirkungsgradeinbußen. Des Weiteren ist es bekannt, zum Beispiel bei Armbanduhren, deren Ziffernblatt eine Solarzelle aufweist, auf dieser Solarzelle ein separates Interferenzfilter anzubringen, um einen Farbeindruck zu erzeugen. Diese Vorgehensweise bringt stets mindestens einen zusätzlichen Produktionsschritt mit sich und bedingt zudem, dass zusätzliches Material verbaut werden muss.

In der WO 2009/042497 A2 wird ein interferometrischer Modulator (IMOD) für ein mikroelektromechanisches System (MEMS) beschrieben, das von der Lichteinfallseite betrachtet eine Schutz-, Elektroden- und Absorberschicht sowie eine so genannte optische Resonanzschicht und einen Reflektor umfasst. Bei dieser Resonanzschicht kann es sich zum Beispiel um einen Luft enthaltenden Hohlraum oder um eine Schicht aus einem leitenden oder nicht leitenden Material handeln. Durch die Anbringung der optischen Resonanz- sowie der Reflektorschicht unterhalb der lichtumwandelnden Absorberschicht soll der Wirkungsgrad nochmals erhöht werden können. Gemäß der WO 2009/085601 A2 lassen sich die in der WO 2009/042497 A2 beschriebenen photovoltaischen Systeme nochmals dadurch in ihrem Wirkungsgrad verbessern, dass man eine Vielzahl an dichromatischen Filtern vorsieht. Solarzellen bzw. -module mit einem zusätzlichen Interferenzfilter auszustatten, findet man zum Beispiel beschrieben in der JP 2000 208 793 A, JP 09307132 A, JP 60148174 A, JP 2002 148 362 A, JP 601 425 76 A, JP 2001 217 444 A und JP 11 295725 A.

Aus der EP 468 475 A1 geht ein amorpher Oxidfilm hervor, der im Wesentlichen zusammengesetzt ist aus einem Zirkonium und Silizium enthaltenden Oxid (ZrSi_{z}O_{y}), bei dem das Atomverhältnis z von Si zu Zr 0,05 ≤ z < 19 und das Atomverhältnis y von O zu Zr 2,1 ≤ y < 40 beträgt. Mit einer solchen amorphen Oxidfilmschicht soll ein die Reflexion verhindernder Überzug für ein Wärmestrahlung reflektierendes Glas erhalten werden, der über eine gute chemische Beständigkeit sowie mechanische Abriebbeständigkeit und damit über eine gute Haltbarkeit verfügt. Gemäß der DE 10 2004 005 050 A1 lässt sich die Energieumwandlung von Strahlung in elektrischen Strom mittels farbselektiver Interferenzfilterspiegel erhöhen, welche die Sonnenstrahlung in verschiedene Wellenlängenbereiche aufsplitten und auf mehrere für verschiedene Lichtfarben optimierte Halbleiter photovoltaisch konzentrieren. Hierfür wird das Sonnenlicht mit Hilfe beweglich angeordneter Interferenzspiegelfolien in mindestens zwei spektrale Wellenlängenbereiche getrennt.

Alternativ kann man bislang allenfalls noch von der Eigenfarbe der unterschiedlichen Modultypen Gebrauch machen. Bei diesem Ansatz diktiert jedoch regelmäßig die gewünschte Farbe das zu verwendende Modulsystem. Mit Dünnschichtsolarzellen auf der Basis von CdTe geht ein schwarzgrüner Farbeindruck einher, mit amorphen Siliziumsolarzellen auf einem Glassubstrat ein schwarzvioletter bis rötlich brauner Farbeindruck, mit amorphen Tripel-Siliziumsolarzellen mit Metallsubstraten ein anthrazit-blau-violetter Farbeindruck, mit texturierten monokristallinen Solarzellen ein Anthrazit-Farbeindruck, mit monokristallinen Siliziumsolarzellen ein dunkelblauer Farbeindruck und mit multikristallinen Solarzellen ein königsblauer Farbeindruck. Die mit herkömmlichen Solarzellen erzielbaren Farben gehen bislang in der Regel auf die für den jeweiligen Solarzellentyp charakteristischen Absorbermaterialen zurück und sind daher auch nicht veränderlich.

Es wäre wünschenswert, auf Bauteile wie z.B. Solarzellen bzw. -module zugreifen zu können, die ein farbiges Erscheinungsbild haben und die auf einfache und zuverlässige Weise zugänglich sind, ohne dass herkömmliche Herstellverfahren vollständig ersetzt werden müssen. Der vorliegenden Erfindung lag daher die Aufgabe zu Grunde, Bauteile wie z.B. Solarzellen bzw. -module verfügbar zu machen, die ein farbiges Erscheinungsbild mit einem durchgehend einheitlichen Farbton über eine Fläche des Bauteils, z.B. der Solarzelle bzw. -des moduls, liefern, das gezielt eingestellt werden kann. Der vorliegenden Erfindung lag ebenfalls die Aufgabe zu Grunde, solche farbigen Bauteile wie z.B. Solarzellen bzw. -module zugänglich zu machen, die trotz des farbigen Erscheinungsbildes einen höchstmöglichen Wirkungsgrad zulassen, d.h. durch die Einbringung von Farbe soll die Modulleistung allenfalls nur unwesentlich verringert werden. Ferner lag der vorliegenden Erfindung die Aufgabe zu Grunde, ein Verfahren verfügbar zu machen, mit dem farbige Bauteile wie z.B. farbige Solarzellen bzw. - module kostengünstig und zuverlässig auch in der Großserie herstellbar sind.

Demgemäß wurde ein Verfahren zur Herstellung eines Substrats mit einer farbigen Interferenzfilterschicht, enthaltend polykristallines Metalloxid oder polykristalline Metalloxide, durch physikalische oder chemische Gasphasenabscheidung mit einer Beschichtungsanlage, insbesondere unter Einsatz eines Sputtergases, gefunden, bei dem man aus der Gasphase mindestens zwei, insbesondere mindestens sechs, Beschichtungslagen jeweils unter Ausbildung von polykristallinen Metalloxiden abscheidet mit einer durchschnittlichen Dicke der jeweiligen Beschichtungslagen im Bereich von etwa 50 nm bis 350 nm, insbesondere im Bereich von etwa 90 nm bis 210 nm und besonders bevorzugt im Bereich von etwa 105 nm oder 110 nm bis etwa 190 nm oder 200 nm, wobei die gemittelten atomaren Anteile mindestens eines, insbesondere jedes einzelnen, der in jeweils mindestens zwei, insbesondere sämtlichen, Beschichtungslagen enthaltenen Metalle um nicht mehr als +/-20 Atom-%, vorzugsweise um nicht mehr als +/-10 Atom-% und besonders bevorzugt um nicht mehr als +/-5 Atom-%, noch weiter bevorzugt um nicht mehr als +/-2 Atom-% und noch weiter bevorzugt um nicht mehr als +/-1 Atom-%, von der gemittelten Zusammensetzung der Interferenzfilterschicht abweichen, wobei 100 Atom-% die Summe aller in der Schicht enthaltenen Metalle bezeichnet.

In einer Weiterentwicklung wurde ferner ein Verfahren zur Herstellung eines Substrats mit einer farbigen Interferenzfilterschicht, enthaltend polykristallines Metalloxid oder polykristalline Metalloxide, durch physikalische und/oder chemische Gasphasenabscheidung, insbesondere unter Einsatz eines Sputtergases, gefunden, umfassend die Schritte
a1) Zurverfügungstellung mindestens einer ersten Beschichtungsanlage zur, insbesondere physikalischen, Gasphasenabscheidung, enthaltend mindestens eine Beschichtungsquelle A, ausstattbar mit oder enthaltend physikalisch verdampfbares oder zerstäubbares Metall- oder Metalloxidmaterial, insbesondere ein Metall- oder Metalloxid-Sputtertarget, mit mindestens einer ersten Materialbeschichtungszone, insbesondere einer Sputter-Erosionszone, und mindestens einer zweiten Materialbeschichtungszone, insbesondere einer Sputter-Erosionszone, sowie gegebenenfalls mindestens einer r-ten Materialbeschichtungszone, insbesondere einer Sputter-Erosionszone, wobei r eine natürliche Zahl größer 2 ist, die zumindest abschnittsweise voneinander beabstandet nebeneinander entlang einer ersten Erstreckungsrichtung der Beschichtungsquelle A, insbesondere im Wesentlichen parallel, verlaufen,
b1) Zurverfügungstellung mindestens eines Substrats mit einer beschichtbaren bzw. beschichteten Oberfläche,
c1) Vorbeiführen der beschichtbaren bzw. beschichteten Oberfläche des Substrats, insbesondere in einem im Wesentlichen konstanten Abstand KA1 und/oder mit einer im Wesentlichen konstanten Geschwindigkeit VA1, an der ersten Beschichtungsquelle A unter Abscheidung von polykristallinem Metalloxid in der Weise, dass auf der beschichtbaren bzw. beschichteten Oberfläche zunächst erstes Material abgeschieden wird, das seinen Ursprung in der ersten Materialbeschichtungszone der ersten Beschichtungsquelle A hat, resultierend in einer ersten Beschichtungslage, dass auf dieses erste Material zweites Material abgeschieden wird, das seinen Ursprung in der zweiten Materialbeschichtungszone der ersten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der ersten Beschichtungsquelle A hat, resultierend in einer r-ten Beschichtungslage, und dass nach dem Vorbeifahren an der ersten Beschichtungsquelle A ein erster Schichtauftrag A1 aus zwei bzw. r Beschichtungslagen erhalten wird, wobei die durchschnittlichen Dicken der jeweiligen Beschichtungslagen auf einen Bereich von etwa 50 nm bis 350 nm, insbesondere von etwa 90 nm bis 210 nm und besonders bevorzugt im Bereich von etwa 105 nm oder 110 nm bis etwa 190 nm oder 200 nm, eingestellt werden,
c2) gegebenenfalls ein- oder mehrmaliges Vorbeiführen der gemäß Schritt c1) erhaltenen beschichteten Substratoberfläche, insbesondere in einem im Wesentlichen konstanten Abstand KA2 und/oder mit einer im Wesentlichen konstanten Geschwindigkeit VA2, an der zweiten Beschichtungsquelle A oder der ersten Beschichtungsquelle A unter Abscheidung von polykristallinem Metalloxid in der Weise, dass auf dem Schichtauftrag gemäß Schritt c1) erstes Material abgeschieden wird, das seinen Ursprung in der ersten Materialbeschichtungszone der zweiten Beschichtungsquelle A oder der ersten oder zweiten Materialbeschichtungszone der ersten Beschichtungsquelle A hat, resultierend in einer ersten Beschichtungslage, dass auf dieses erste Material zweites Material abgeschieden wird, das seinen Ursprung in der zweiten Materialbeschichtungszone der zweiten Beschichtungsquelle A oder der ersten bzw. zweiten Materialbeschichtungszone der ersten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der zweiten Beschichtungsquelle A oder der ersten Beschichtungsquelle A hat, resultierend in einer r-ten Beschichtungslage, und dass nach dem Vorbeifahren an der zweiten Beschichtungsquelle A oder der ersten Beschichtungsquelle A ein zweiter Schichtauftrag A2 aus zwei bzw. r Beschichtungslagen erhalten wird, wobei die durchschnittlichen Dicken der jeweiligen Beschichtungslagen auf einen Bereich von etwa 50 nm bis 350 nm, insbesondere von etwa 90 nm bis 210 nm und besonders bevorzugt im Bereich von etwa 105 nm oder 110 nm bis etwa 190 nm oder 200 nm, eingestellt werden,
cn) gegebenenfalls ein- oder mehrmaliges Vorbeiführen der gemäß Schritt c2) oder einem nachfolgenden Schritt cn) erhaltenen beschichteten Substratoberfläche, insbesondere in einem im Wesentlichen konstanten Abstand KAn und/oder mit einer im Wesentlichen konstanten Geschwindigkeit VAn, an der dritten bzw. (n+1)-ten Beschichtungsquelle A oder an der ersten und/oder zweiten Beschichtungsquelle A unter Abscheidung von polykristallinem Metalloxid in der Weise, dass auf dem Schichtauftrag gemäß Schritt c2) bzw. Schritt cn)
   zunächst erstes Material abgeschieden wird, das seinen Ursprung in der ersten Materialbeschichtungszone der n-ten Beschichtungsquelle A hat, resultierend in einer ersten Beschichtungslage, dass auf dieses erste Material zweites Material abgeschieden wird, das seinen Ursprung in der zweiten Materialbeschichtungszone der n-ten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der ersten, zweiten oder n-ten Beschichtungsquelle A hat, resultierend in einer r-ten Beschichtungslage, oder dass
   ein erstes Material abgeschieden wird, das seinen Ursprung in der ersten oder zweiten Materialbeschichtungszone der ersten oder zweiten Beschichtungsquelle A hat, resultierend in einer ersten Beschichtungslage, dass auf dieses erste Material zweites Material abgeschieden wird, das seinen Ursprung in der zweiten bzw. ersten Materialbeschichtungszone der ersten oder zweiten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der ersten oder zweiten Beschichtungsquelle A hat, resultierend in einer r-ten Beschichtungslage,
   und dass nach dem Vorbeifahren an der ersten, zweiten bzw. n-ten Bedampfungsquelle A ein n-ter Schichtauftrag An aus zwei bzw. r Beschichtungslagen erhalten wird, wobei die durchschnittlichen Dicken der jeweiligen Beschichtungslagen auf einen Bereich von etwa 50 nm bis 350 nm, insbesondere von etwa 90 nm bis 210 nm und besonders bevorzugt im Bereich von etwa 105 nm oder 110 nm bis etwa 190 nm oder 200 nm, eingestellt werden,
   wobei n eine natürliche Zahl größer 2 ist, wobei die 1, 2 oder n Beschichtungsquellen A nebeneinander entlang der Fahrstrecke des Substrats angeordnet oder anordbar sind und wobei die 2 oder r Materialbeschichtungszonen beabstandet nebeneinander angeordnet sind, und wobei durch die 1, 2 oder n Beschichtungsquellen A, an denen die beschichtbare bzw. beschichtete Oberfläche des Substrats jeweils zwecks physikalischer Abscheidung aus der Gasphase jeweils ein- oder mehrmals vorbeigeführt wird, eine Interferenzfilterschicht mit einer durchschnittlichen Dicke DIF im Bereich von etwa 180 nm bis 10.000 nm, insbesondere im Bereich von etwa 250 nm bis 2.500 nm, erhalten wird;
   wobei die Bewegungsrichtung des Substrats mit der beschichtbaren bzw. beschichteten Oberfläche und die erste Erstreckungsrichtung in einem Winkel zueinander ausgerichtet sind und insbesondere einen im Wesentlichen rechten Winkel bilden,
oder umfassend die Schritte
x1) Zurverfügungstellung mindestens einer zweiten Beschichtungsanlage zur physikalischen oder chemischen Gasphasenabscheidung, enthaltend mindestens zwei Beschichtungsquellen B, ausstattbar mit oder enthaltend verdampfbares Metall- oder Metalloxidmaterial oder eine verdampfbare und zersetzbare metallorganische Verbindung, mit einer dritten, insbesondere entlang einer ersten Erstreckungsrichtung der Beschichtungsquelle B verlaufenden, Materialbeschichtungszone,
y1) Zurverfügungstellung mindestens eines Substrats mit einer beschichtbaren bzw. beschichteten Oberfläche,
z1) Vorbeiführen der beschichtbaren bzw. beschichteten Oberfläche eines Substrats, insbesondere in einem im Wesentlichen konstanten Abstand KA1 und/oder mit einer im Wesentlichen konstanten Geschwindigkeit VA1, an der ersten Beschichtungsquelle B unter Abscheidung von polykristallinem Metalloxid in der Weise, dass auf der beschichtbaren bzw. beschichteten Oberfläche Material abgeschieden wird, das seinen Ursprung in der ersten Beschichtungsquelle B hat, und dass nach dem Vorbeifahren an der ersten Beschichtungsquelle B eine erste Beschichtungslage B 1 mit einer durchschnittlichen Dicke K1 im Bereich von etwa 50 nm bis 350 nm, insbesondere im Bereich von etwa 90 nm bis 210 nm und besonders bevorzugt im Bereich von etwa 105 nm oder 110 nm bis etwa 190 nm oder 200 nm, erhalten wird, und
z2) ein- oder mehrmaliges Vorbeiführen der gemäß Schritt z1) erhaltenen beschichteten Substratoberfläche, insbesondere in einem im Wesentlichen konstanten Abstand KA2 und/oder mit einer im Wesentlichen konstanten Geschwindigkeit VA2, an der zweiten Beschichtungsquelle B oder an der ersten Beschichtungsquelle B unter Abscheidung von polykristallinem Metalloxid in der Weise, dass auf der Beschichtungslage gemäß Schritt z1) Material abgeschieden wird, das seinen Ursprung in der zweiten Beschichtungsquelle B bzw. der ersten Beschichtungsquelle B hat, und dass nach dem Vorbeifahren an der zweiten Beschichtungsquelle B oder der ersten Beschichtungsquelle B eine zweite Beschichtungslage B2 mit einer durchschnittlichen Dicke K2 im Bereich von etwa 50 nm bis 350 nm, insbesondere im Bereich von etwa 90 nm bis 210 nm und besonders bevorzugt im Bereich von etwa 105 nm oder 110 nm bis etwa 190 nm oder 200 nm, erhalten wird,
zm) gegebenenfalls ein- oder mehrmaliges Vorbeiführen der gemäß Schritt z2) oder einem nachfolgenden Schritt zm) erhaltenen beschichteten Substratoberfläche, insbesondere in einem im Wesentlichen konstanten Abstand KAm und/oder mit einer im Wesentlichen konstanten Geschwindigkeit VAm, an der m-ten Beschichtungsquelle B unter Abscheidung von polykristallinem Metalloxid in der Weise,
   dass auf der Beschichtungslage gemäß Schritt z2) bzw. Schritt zm) Material abgeschieden wird, das seinen Ursprung in der dritten bzw. (m+1)-ten Beschichtungsquelle B hat, an der m-ten Beschichtungsquelle B unter Abscheidung von polykristallinem Metalloxid in der Weise,
   oder dass auf der Beschichtungslage gemäß Schritt z2) bzw. Schritt zm) Material abgeschieden wird, das seinen Ursprung in der ersten oder zweiten Beschichtungsquelle B hat,
   und dass nach dem Vorbeifahren an der m-ten Beschichtungsquelle B oder an der ersten und/oder zweiten Beschichtungsquelle B eine m-te Beschichtungslage Bm mit einer durchschnittlichen Dicke Km im Bereich von etwa 50 nm bis 350 nm, insbesondere im Bereich von etwa 90 nm bis 210 nm und besonders bevorzugt im Bereich von etwa 105 nm oder 110 nm bis etwa 190 nm oder 200 nm, erhalten wird,
   wobei m eine natürliche Zahl größer 2 ist, wobei die 1, 2 oder m Beschichtungsquellen B nebeneinander entlang der Fahrstrecke des Substrats angeordnet oder anordbar sind und wobei durch die 1, 2 oder m Beschichtungsquellen, an denen die beschichtbare bzw. beschichtete Oberfläche des Substrats jeweils zwecks physikalischer oder chemischer Abscheidung aus der Gasphase jeweils ein- oder mehrmals vorbeigeführt wird, eine Interferenzfilterschicht mit einer durchschnittlichen Dicke DIF im Bereich von etwa 180 nm bis 10.000 nm, insbesondere im Bereich von etwa 250 nm bis 2.500 nm, erhalten wird, und wobei gegebenenfalls die Bewegungsrichtung des Substrats mit der beschichtbaren bzw. beschichteten Oberfläche und die erste Erstreckungsrichtung in einem Winkel zueinander ausgerichtet sind und insbesondere einen im Wesentlichen rechten Winkel bilden; und
wobei die gemittelten atomaren Anteile mindestens eines, insbesondere jedes einzelnen, der in jeweils mindestens zwei, insbesondere sämtlichen, Beschichtungslagen, enthaltenen Metalle um nicht mehr als +/-20 Atom-%, vorzugsweise um nicht mehr als +/-10 Atom-% und besonders bevorzugt um nicht mehr als +/-5 Atom- %, noch weiter bevorzugt um nicht mehr als +/-2 Atom-% und noch weiter bevorzugt um nicht mehr als +/-1 Atom-%, von der gemittelten Zusammensetzung der Interferenzfilterschicht abweichen, wobei 100 Atom-% die Summe aller in der Schicht enthaltenen Metalle bezeichnet. Diese Verfahrensvariante stellt insbesondere auch eine Weiterentwicklung des vorangehend spezifizierten erfindungsgemäßens Verfahrens dar.

Die mit dem erfindungsgemäßen Verfahren erhältlichen Beschichtungslagen zeichnen sich durch eine recht einheitliche Zusammensetzung aus. Für jede Beschichtungslage wird vorzugsweise auf ein und dasselbe Metalloxidmaterial zurückgegriffen. Demnach verwendet man vorzugsweise für jede Beschichtungsquelle A bzw., jede Materialbeschichtungszone der ersten Beschichtungsanlage übereinstimmendes Ausgangsmaterial, beispielsweise in Form eines Sputtertargets. Des Weiteren ist ein solches erfindungsgemäßes Verfahren bevorzugt, mit dem Beschichtungslagen erhalten werden, die sämtlichst in ihrer durchschnittlichen Dicke im Wesentlichen übereinstimmen. Selbstverständliche ist es hiervon abweichend auch möglich, innerhalb einer Metalloxidschicht eine oder mehrere Beschichtungslagen mit voneinander abweichenden durchschnittlichen Dicken zuhaben. Des Weiteren wird vorzugsweise die Geschwindigkeit, mit der das Substrat, enthaltend die beschichtbare bzw. beschichtete Oberfläche, an den Beschichtungsquellen vorbeigeführt wird, konstant gehalten, d.h. die Geschwindigkeiten VA1, VA2 und sofern weitere Beschichtungsquellen eingesetzt werden Van stimmen überein. Dieses trifft insbesondere auf geradlinige Fahrtwege des Substrats entlang der Beschichtungsquellen zu. Selbstverständlich ist es in einer anderen Ausführungsform ebenfalls möglich, bereits die Geschwindigkeit, mit der das Substrat an einer Beschichtungsquelle vorbeigefahren wird, nicht konstant zuhalten bzw. stetig ansteigen zu lassen. Auch ist es möglich, für die Geschwindigkeit, mit dem das Substrat in den jeweiligen Beschichtungsquellen vorbeigefahren wird, unterschiedlich einzustellen. Gemäß einer weiteren Ausführungsform können die zu beschichtenden Substratoberflächen auch entlang eines gebogenen Fahrtweges, beispielsweise auf einer Kreisbahn, an einer oder mehreren Beschichtungsquellen vorbeigeführt werden. Wird die Substratoberfläche auf einer Kreisbahn bewegt, reicht im Grunde bereits nur eine Beschichtungsquelle aus, um eine Vielzahl an die Metalloxidschicht bildenden Beschichtungslagen zu erhalten. Dieses ist in gleicher Weise möglich, wenn die Substratoberfläche vor einer Beschichtungsquelle vor und zurück verschoben wird, quasi der Bewegung eines Pendels folgend. Auch bei dieser Variante kann man mit nur einer Beschichtungsquelle eine Vielzahl an Beschichtungslagen auftragen. Übliche Transportgeschwindigkeiten liegen im Bereich von 0,01 m/min bis 10 m/min, vorzugsweise im Bereich von 0,2 m/min bis 2 m/min. Auch ist es darüber hinaus bevorzugt, wenn der Abstand der beschichtbaren bzw. beschichteten Oberfläche dieses Substrats zu den Beschichtungsquellen entlang des Fahrweges konstant gehalten wird. Selbstverständlich kann dieser Abstand im Bereich einer oder mehrere Beschichtungsquellen auch variabel gestaltet werden. Üblicherweise liegt der Abstand der beschichtbaren bzw. beschichteten Oberfläche des Substrats von der Beschichtungsquelle im Bereich von 10 mm bis 1000 mm, bei Magnetronsputterquellen bevorzugt im Bereich von 40 mm bis 200 mm.

Dabei kann in einer Ausführungsform vorgesehen sein, dass die erste Beschichtungsanlage zur, insbesondere physikalischen, Gasphasenabscheidung eine Magnetron-Sputteranlage umfasst und dass die Beschichtungsquelle ein Magnetron umfasst bzw. darstellt mit einer Vorder- und einer Rückseite sowie mit einer Längs- und einer Quererstreckung, enthaltend mindestens ein Magnetsystem hinter oder benachbart zur Oberseite, das beabstandet voneinander außenliegende und mindestens einen innenliegenden Permanentmagneten in Nord-Süd-Nord-oder Süd-Nord-Süd-Anordnung umfasst, vorzugsweise ausgerichtet und angeordnet entlang der ersten Erstreckungsrichtung des Magnetrons.

Die Quererstreckung des Magnetrons stimmt in einer Ausführungsform im Wesentlichen mit der Bewegungsrichtung der beschichtbaren bzw. beschichteten Oberfläche des Substrats überein, während die Längserstreckung des Magnetrons übereinstimmt mit dem Verlauf der beabstandet ist, insbesondere parallel, vorliegenden permanenten Magneten und damit auch mit der Verlauf der Materialbeschichtungszonen.

Geeignete Magnetron-Sputteranlagen sind dem Fachmann bekannt und finden sich z.B. beschrieben bei R.A. Haefer, Oberflächen- und Dünnschicht-Technologie - Teil 1: Beschichtungen und Oberflächen, Springer Verlag, 1987. Besonders bevorzugt wird für das erfindungsgemäße Verfahren auf eine DC-Magnetron-Sputteranlage zurückgegriffen.

In einer zweckmäßigen Ausgestaltung kann vorgesehen sein, dass je ein, insbesondere planares, Metall- oder Metalloxidtarget, insbesondere Rechtecktarget, auf der Vorderseite des Magnetrons angeordnet ist, so dass das Magnetsystem zumindest bereichsweise, insbesondere vollständig, abgedeckt wird. Die bei einem Magnetron vorzugsweise vorliegenden zwei Materialbeschichtungszonen verlaufen vorteilhafterweise im Wesentlichen parallel entlang der Erstreckungsrichtung der Beschichtungsquelle. Der durchschnittliche Abstand dieser Materialbeschichtungszonen liegt in einer Ausführungsform mit zwei Beschichtungszonen im Bereich von 40 mm bis 400 mm, bevorzugt im Bereich von 80 mm bis 200 mm, besonders bevorzugt im Bereich von 115 mm bis 165 mm mm. Des Weiteren kann vorgesehen sein, dass der durchschnittliche Abstand zwischen den benachbarten Beschichtungszonen benachbarter Beschichtungsquellen bzw. Magnetrons in einer Ausführungsform von z.B. mindestens 60 mm bis zu einem Wert, der durch die Länge der Anlage begrenzt wird, z.B. 3500 mm, vorzugsweise im Bereich von 100 mm 2000 mm und ferner bevorzugt im Bereich von 200 mm bis 500 mm liegt.

Geeignete zweite Beschichtungsanlagen sind solche, mit denen sich Metalloxidschichten z.B. mittels thermischen Bedampfens, Elektronenstrahlbeaufschlagung oder mit dem CVD-Verfahren, insbesondere mittels Plasma-aktivierter CVD (plasma-enhanced CVD, PECVD) erhalten lassen.

Gemäß einer Ausführungsform des erfindungsgemäßen Verfahrens umfasst die Beschichtungsanlage zur physikalischen Gasphasenabscheidung eine Magnetronsputtereinrichtung, welche ein um eine axiale Längsachse drehbar gelagertes zylindrisches Rohrtarget umfasst mit einem im Inneren des Rohrtargets angeordneten Magnetsystem.

Die aus polykristallinem Metalloxid gebildete Interferenzfilterschicht umfasst in einer Ausgestaltung mindestens zwei, vorzugsweise mindestens sechs, Beschichtungslagen.

In einer bevorzugten Ausgestaltung des erfindungsgemäßen Verfahrens stellt das Substrat eine Solarzelle oder ein Solarmodul oder einen Bestandteil hiervon und/oder dass die farbige Interferenzfilterschicht eine leitfähige lichtdurchlässige Elektrodenschicht oder Frontelektrodenschicht, insbesondere einer Solarzelle bzw. eines Solarmoduls, dar.

Des Weiteren kann bei dem erfindungsgemäßen Verfahren vorgesehen sein, dass die durchschnittlichen Dicken des ersten, zweiten und/oder n-ten Schichtauftrags oder mindestens zweier, insbesondere sämtlicher, Beschichtungslagen im Wesentlichen übereinstimmen und/oder in den Grenzen +/- 20 %, vorzugsweise +/- 10 %, besonders bevorzugt +/- 5 % und noch weiter bevorzugt um nicht mehr als +/-2 Atom-%, variieren.

In einer besonders zweckmäßigen Ausgestaltung, insbesondere bei der Herstellung von Solarzellen oder Solarmodulen, sieht das erfindungsgemäße Verfahren vor, dass das Metalloxid Zinkoxid oder ein mit, insbesondere bis zu etwa 5 Gew.-% an, Aluminium oder Aluminiumoxid, Bor oder Boroxid, Gallium oder Galliumoxid und/oder Indium oder Indiumoxid angereichertes Zinkoxid darstellt bzw. umfasst.

Vorteilhafterweise umfasst der erste, zweite, oder n-te Schichtauftrag zwei Beschichtungslagen , die jeweils auf eine Materialbeschichtungszone zurückgehen.

Als ganz besonders vorteilhaft, insbesondere für die Herstellung von farbigen Solarmodulen und farbigen Solarzellen, hat sich eine Weiterentwicklung erwiesen, gemäß der mindestens eines, insbesondere jedes einzelne, der in der Interferenzfilterschicht enthaltenen Metalle tiefenaufgelöst über das gesamte Volumen derselben um nicht mehr als +/-20 Atom-%, insbesondere um nicht mehr als +/-10 Atom-%, besonders bevorzugt nicht mehr als +/-5 Atom-%, noch weiter bevorzugt um nicht mehr als +/-2 Atom-% und noch weiter bevorzugt um nicht mehr als +/-1 Atom-%, von der gemittelten Zusammensetzung der Metalle in dieser Interferenzfilterschicht abweicht, wobei 100 Atom-% die Summe aller in der Schicht enthaltenen Metalle bezeichnet. Eine tiefenaufgelöste Bestimmung des Metallgehalts findet im Sinne der Erfindung regelmäßig parallel zur Substratnormalen, d.h. senkrecht zum Substrat statt. Beispielsweise können in einer Ausführungsform Messpunkte in Abständen von 10 nm bis 20 nm parallel zur Substratnormalen vermessen werden, beispielsweise mittels Sekundärionen-Massenspektrometer-Analyser (SIMS, secondary ion mass spectroscopy).

Hierbei kann in einer vorteilhaften Ausgestaltung vorgesehen sein, dass die Metalloxide in der Weise abgeschieden werden, dass die atomaren Anteile mindestens eines, insbesondere jedes einzelnen der in dem ersten, zweiten, und/oder n-ten Schichtauftrag und/oder in mindestens einer, insbesondere sämtlichen, Beschichtungslagen enthaltenen Metalle jeweils im Wesentlichen übereinstimmen.

Das erfindungsgemäße Verfahren zeichnet sich des Weiteren in einer weiteren Ausführungsform dadurch aus, dass man als Sputtergas ein Inertgas oder ein Inertgasgemisch, insbesondere Argon bzw. umfassend Argon, verwendet oder dass man als Sputtergas ein Inertgas oder ein Inertgasgemisch, insbesondere Argon bzw. umfassend Argon, verwendet, das einen Volumenanteil an Sauerstoff enthält, der insbesondere derart eingestellt wird, dass das Metalloxid unterstöchiometrisch bezüglich Sauerstoff, gemittelt über das Volumen des ersten, zweiten, m-ten und/oder n-ten Materialauftrags, in dem ersten, zweiten, m-ten bzw. n-ten Materialauftrag vorliegt. Exemplarisch sei an dieser Stelle auf solche Gasgemische verwiesen, welche neben dem Inertgas, vorzugsweise Argon, 0,01 bis 5 Vol.-%, vorzugsweise 0,2 bis 2 Vol.-% an Sauerstoff enthalten.

Setzt man dem Sputtergas Sauerstoff zu, ergibt dies die Möglichkeit, nicht mehr nur von einem keramischen Sputtertarget, beispielsweise enthaltend Zinkoxid, auszugehen, sondern von einem Metalltarget oder Metall-Legierungs-Target, sodass sich in Anwesenheit von Sauerstoff erst bei der Beschichtung selber das Metalloxid bildet. Für diesen Fall ist die Menge an Sauerstoff derart hoch zu wählen, dass die gesamte Menge an Metall zu dem Metalloxid umgesetzt werden kann.

Bei dem erfindungsgemäßen Verfahren kommt es gemäß einer besonders vorteilhaften Ausgestaltung insbesondere darauf an, dass die durchschnittliche Dicke der ersten, zweiten und n-ten Schichtaufträge und/oder mindestens zweier, insbesondere sämtlicher, Beschichtungslagen derart gewählt wird, dass sich bei Einstrahlung von sichtbarem Licht durch lichtoptische Interferenz ein schmalbandiges Reflexionsbandpassfilter ausbildet, das im Wellenlängenbereich von 360 nm bis 860 nm eine auf die Wellenlänge des Reflexionsmaximums bezogene Halbwertsbreite von maximal 35%, insbesondere maximal 25%, aufweist.

Des Weiteren kann bei dem erfindungsgemäßen Verfahren in einer Ausführungsvariante berücksichtigt werden, dass das Substrat mit der beschichtbaren oder beschichteten Oberfläche zwecks Gasphasenabscheidung an der bzw. den Beschichtungsquellen, insbesondere jeweils enthaltend mindestens zwei Materialbeschichtungszonen, in im Wesentlichen gleichen Abstand und mit im Wesentlichen gleicher Geschwindigkeit vorbeigeführt wird.

Die der Erfindung zu Grunde liegende Aufgabe wird des Weiteren gelöst durch ein Substrat, enthaltend eine farbige, lichtdurchlässige polykristalline Metalloxidschicht, erhalten durch physikalische oder chemische Gasphasenabscheidung, als Interferenzfilterschicht, umfassend mindestens zwei, insbesondere mindestens sechs, Beschichtungslagen, wobei die gemittelten atomaren Anteile mindestens eines, insbesondere jedes einzelnen, der in jeweils mindestens zwei, insbesondere sämtlichen, Beschichtungslagen, enthaltenen Metalle um nicht mehr als +/-20 Atom-%, vorzugsweise um nicht mehr als +/-10 Atom-% und besonders bevorzugt um nicht mehr als +/-5 Atom-%, noch weiter bevorzugt um nicht mehr als +/-2 Atom-% und noch weiter bevorzugt um nicht mehr als +/-1 Atom-%, von der gemittelten Zusammensetzung der Metalloxidschicht abweichen, wobei 100 Atom-% die Summe aller in der Schicht enthaltenen Metalle bezeichnet, und wobei die durchschnittlichen Dicken der Beschichtungslagen im Bereich von etwa 50 nm bis 350 nm, insbesondere im Bereich von etwa 90 nm bis 210 nm und besonders bevorzugt jeweils im Bereich von etwa 105 nm oder 110 nm bis etwa 190 nm oder 200 nm, liegen. Das erfindungsgemäße Substrat ist in besonders vorteilhafter Weise durch das erfindungsgemäße Verfahren zugänglich. Bei der die Interferenzschicht bildenden Metalloxidschicht des erfindungsgemäßen Substrats kann man in einer bevorzugten Ausgestaltung von einem so genannten Einmaterialsystem sprechen, d.h. neben dem Metalloxid können allenfalls noch unterstöchiometrisches Metalloxid, beispielsweise unterstöchiometrisches Zinkoxid, und/oder Dotiermaterialien, beispielsweise in Mengen von nicht mehr als 5% der Stoffmenge der zugesetzten Verbindung, wie sie für die Erzeugung der Leitfähigkeit von Metalloxidschichten, beispielsweise basierend auf Zinkoxid, erforderlich sind, zugegen sein.

Die Interferenzfilterschicht bildende polykristalline Metalloxidschicht ist im Sinne der Erfindung insbesondere dann lichtdurchlässig, wenn der Mittelwert der Transmission im Bereich von 400 nm bis 800 nm größer als 60%, vorzugsweise größer als 70% und besonders bevorzugt größer als 80% ist, wobei bei der Messung des Weißstandards (Nullmessung) ein unbeschichtetes transparentes Trägermaterial (wie z.B. Glas) mitzumessen ist.

In einer besonders bevorzugten Ausgestaltung stellen das erfindungsgemäße Substrat eine Solarzelle oder ein Solarmodul oder einen Bestandteil hiervon und die farbige, lichtdurchlässige polykristalline Metalloxidschicht eine Interferenzfilterschicht und gleichzeitig eine Elektrodenschicht, insbesondere Frontelektrodenschicht, dar. Metalloxidschichten leitfähig auszustatten, beispielsweise Zinkoxidschichten, um sie als Elektrodenschichten bzw. Frontelektrodenschichten einsetzten zu können, ist dem Fachmann grundsätzlich bekannt. Hierfür wird regelmäßig eine Anreichung bzw. Dotierung mit Metallen bzw. Metalloxiden vorgenommen, deren Gruppennummer gemäß dem Periodensystem der Elemente sich um +/- 1 von derjenigen, in dem das Metall steht, auf dem die Metalloxidschicht basiert, unterscheidet, wobei nicht zwischen Haupt- und Nebengruppen unterschieden wird. Beispielsweise werden nach dieser Definition die Metalle Beryllium, Magnesium, Kalzium, Strontium, Barium und Radium, aber auch Zink, Kadmium und Quecksilber der zweiten Gruppe zugeordnet. Exemplarisch sei als geeignetes System ZnO:Al₂O₃ genannt, beispielsweise mit einem Aluminium- bzw. Aluminiumoxidanteil von z.B. bis zu 5 Gew.-%. Exemplarisch seien ferner Aluminium- bzw. Aluminiumoxidanteile im Bereich von 0,1 bis 2,5 Gew.-% und im Bereich von 1,0 bis 2,0 Gew.-% genannt. Des weiteren kommen als geeignete Metalloxidsysteme, insbesondere auch für ein Elektroden- bzw. Frontelektrodenschicht, solche auf Basis von SnO₂, gegebenenfalls dotiert mit Fluoriden, oder auf der Basis von In₂O₃, gegebenenfalls dotiert mit Sn bzw. SnO₂, in Frage. Demgemäß wird mit der Erfindung ebenfalls abgestellt auf lichtdurchlässige, leitfähige und nicht-leitfähige Metalloxidschichten, die ein Interferenzfilter darstellen.

Des weiteren umfassen erfindungsgemäße Substrate ebenfalls Flachbildschirme, elektrische Verglasungen oder SAW-Signalfilter, sowie thermo- oder elektrochrome Beschichtungen, die mit der vorangehend beschriebenen Metalloxidschicht ausgestattet sind.

Solche erfindungsgemäßen Substrate sind besonders bevorzugt, bei denen mindestens eines, insbesondere jedes einzelne, der in der Metalloxidschicht enthaltenen Metalle tiefenaufgelöst über das gesamte Volumen derselben um nicht mehr als +/- 20 Atom-%, insbesondere um nicht mehr als +/-10 Atom-%, besonders bevorzugt um nicht mehr als +/- 5 Atom-%, noch weiter bevorzugt um nicht mehr als +/-2 Atom-% und noch weiter bevorzugt um nicht mehr als +/-1 Atom-%, von der gemittelten Zusammensetzung der Metalle in dieser Metalloxidschicht abweicht, wobei 100 Atom-% die Summe aller in der Schicht enthaltenen Metalle bezeichnet.

Hierbei ist von besonderem Vorteil, wenn die atomaren Anteile mindestens eines, insbesondere jedes einzelnen, der in den Beschichtungslagen enthaltenen Metalle jeweils im Wesentlichen übereinstimmen und/oder dass durchschnittliche Dicken mindestens zweier, insbesondere sämtlicher, Beschichtungslagen im Wesentlichen übereinstimmen und/oder maximal in den Grenzen +/- 20 %, vorzugsweise +/- 5 %, besonders bevorzugt +/- 2 %, variieren.

Des Weiteren kann in einer besonders zweckmäßigen Ausgestaltung der erfindungsgemäßen Substrate vorgesehen sein, dass in einem ersten bzw. in ersten Übergangen zwischen, insbesondere sämtlichen einander, benachbarten Lagen, insbesondere Beschichtungslagen, insbesondere in einer Ebene parallel zur Oberfläche des Substrats, eine, insbesondere flächenhafte, Störung des Kristallgefüges vorliegt, mit der eine Brechzahl einhergeht, die sich von der Brechzahl der jeweils benachbarten Kristallgefüge der Lagen, insbesondere Beschichtungslagen, unterscheidet, und/oder dass das polykristalline Metalloxid in Säulenform aufwächst mit der Hauptausrichtung der Mehrzahl der Säulen, insbesondere nahezu sämtlicher Säulen, zumindest entlang eines Abschnitts der Säulen in einem Winkel zur Substratoberfläche, insbesondere im Wesentlichen +/-45°, insbesondere +/-15°, gegen die Normalenrichtung der Substratoberfläche, wobei in einem zweiten bzw. in zweiten Übergängen zwischen benachbarten Säulen eine, insbesondere flächenhafte, Störung des Kristallgefüges vorliegt, mit der eine Brechzahl einhergeht, die sich von der Brechzahl der jeweils benachbarten Kristallgefüge in den Säulen unterscheidet. Die Hauptausrichtung der Säulen kann im Sinne der Erfindung ermittelt werden durch die Verbindungslinie zwischen Anfang und Ende einer Säule innerhalb einer Beschichtungslage. Die Hauptausrichtung eines Abschnitts der Säulen kann im Sinne der Erfindung ermittelt werden durch die Verbindungslinie zwischen dem Anfang- und dem Endpunkt dieses Abschnitts der Säule.

Von besonderem Vorteil sind dabei insbesondere auch solche Ausführungsformen, bei denen in der Metalloxidschicht die flächenhaften Störungen des Kristallgefüges in den zweiten Übergängen benachbarter Säulen zumindest in einer Ebene normal zur Substratoberfläche sichelförmig verformt sind. Die sichelförmige bzw. gebogene oder gekrümmte Gestalt der Kristallsäulen des Metalloxids lässt sich, ohne diese an diese Theorie gebunden zu sein, möglicherweise durch einen so genannten Vorbeifahreffekt erklären. Dadurch, dass man die zu beschichtende Oberfläche relativ zu der Materialbeschichtungszone- bzw. der Beschichtungsquelle bewegt, wird das aufgetragene Beschichtungsmaterial an einem Punkt der Oberfläche unter einem sich änderndem Winkel abgeschieden. Es wird daher vermutet, dass die zumindest abschnittsweise gebogene, gekrümmte bzw. sichelförmige Säulenform auf den Transport der zu beschichtenden Oberfläche vorbei an den jeweiligen Beschichtungsquellen zurückgeführt werden könnte, d.h. das Kristallwachstum vollzieht sich möglicherweise stets in der Richtung, aus der Material angeliefert bzw. aufgetragen wird.

In diesem Zusammenhang sind auch solche Substrate besonders geeignet, bei denen in dem oder den ersten Übergängen und/oder in dem oder den zweiten Übergängen eine Anreicherung an Aluminium, Bor, Gallium und/oder Indium oder deren Oxiden gegeben ist und/oder das Metalloxid, insbesondere Zinkoxid, unterstöchiometrisch in Bezug auf Sauerstoff vorliegt.

Als besonders zweckmäßig haben sich auch solche Substrate erwiesen, bei denen die Brechzahlen der Beschichtungslagen sowie der ersten und zweiten Übergänge und/oder die durchschnittliche Brechzahl der Metalloxidschicht bei einer Wellenlänge von 590 nm im Bereich von 1,2 bis 3,6, insbesondere im Bereich von 1,7 bis 2,5, vorzugsweise oberhalb von 1,95, und besonders bevorzugt im Bereich von 2,0 oder 2,1 bis 2,5, liegen. Farbige bzw. besonders farbintensive erfindungsgemäße Substrate sowie insbesondere Solarmodule erhält man insbesondere dann, wenn man die durchschnittliche Brechzahl der Metalloxidschicht auf Werte oberhalb von 1,95, vorzugsweise im Bereich von 2,0 und darüber, d.h. 2,0 bis 3,6 oder 2,0 oder 2,1 bis 2,5 oder 2,3 einstellt.

Erfindungsgemäße farbige Substrate, insbesondere in Form von Solarmodulen oder Solarzellen, zeichnen sich dadurch aus, dass die farbige, lichtdurchlässige polykristalline Metalloxidschicht elektrisch leitend ist, insbesondere einen spezifischen elektrischen Widerstand aufweist im Bereich von 0 bis 1 Ohm-Meter, vorzugsweise im Bereich von 1 x 10⁻⁷ Ohm-Meter bis 1 x 10⁻³ Ohm-Meter, besonders bevorzugt im Bereich von 2 x 10⁻⁵ Ohm-Meter bis 2 x 10⁻⁴ Ohm-Meter. Bei diesen Solarzellen und Solarmodulen stellt die leitfähige Metalloxidschicht vorzugsweise die Frontelektrode dar. Die vorliegende Erfindung stellt demgemäß ebenfalls ab auf Solarmodule und Solarzellen, insbesondere Dünnschichtsolarmodule und -zellen, beispielsweise basierend auf CIS-, CIGS- oder CIGSSe-Absorberschichten, bei denen die vorangehend und auch nachfolgend beschriebene, aus mindestens zwei Beschichtungslagen gebildete Metalloxidschicht gleichzeitig als Interferenzfilterschicht zur Erzeugung eines Farbeindrucks fungiert.

Die Metalloxidschicht verfügt in den erfindungsgemäßen Substraten gemäß einer Ausgestaltung über eine durchschnittliche Dicke im Bereich von 0,18 µm bis 10 µm, bevorzugt im Bereich von 0,25 µm bis 2,5 µm, aufweist.

Hierbei ist von besonderem Vorteil, wenn die lateralen Abweichungen der Dicke der Beschichtungslagen maximal in den Grenzen +/- 10 %, vorzugsweise +/- 5%, und besonders bevorzugt +/- 2%, variieren.

Für die erfindungsgemäßen Substrate werden in einer Ausführungsform solche Metalloxidschichten eingesetzt, die auf Zinkoxid oder auf Zinkoxid und, insbesondere nicht mehr als 5% der Stoffmenge, vorzugsweise nicht mehr als 2,5% der Stoffmenge an, Aluminium oder Aluminiumoxid, Bor oder Boroxid, Gallium oder Galliumoxid und/oder Indium oder Indiumoxid basieren. Die vorangehend genannten Metalloxidschichten zeichnen sich regelmäßig durch elektrische Leitfähigkeit aus.

Hierbei kann vorgesehen sein, dass das Metalloxid, insbesondere Zinkoxid, in der Metalloxidschicht, gemittelt über das Volumen dieser Metalloxidschicht, unterstöchiometrisch bezüglich Sauerstoff vorliegt.

Bei erfindungsgemäßen Substraten in Form von Solarzellen bzw. Solarmodulen oder Bestandteilen hiervon umfassen, vorzugsweise in dieser Abfolge, eine elektrisch leitfähige Rückelektrodenschicht, eine lichtumwandelnde Absorberschicht, insbesondere auf der Basis eines III-V-Halbleiters oder eines II-VI-Halbleiters oder eines I-III-VI-Halbleiters oder eines organischen Halbleiters, und die Frontelektrodenschicht sowie gegebenenfalls eine Laminierfolie und/oder eine Deckglasscheibe. Geeignete Laminierfolien und Deckglasscheiben für Solarmodule sind dem Fachmann hinlänglich bekannt. Diese sind vorzugsweise transparent. Als bevorzugte Deckglasscheiben kommen häufig so genannte Weißglasscheiben zum Einsatz. Geeignete transparente Laminierfolien basieren z.B. auf thermoplastischen oder vernetzenden Kunststoffen. Exemplarisch sei auf EVA, PVB und Ionomer-Polymere verwiesen.

Die erfindungsgemäßen farbigen Substrate verfügen in einer besonders bevorzugten Ausgestaltung auf der Seite der farbigen Metalloxidschicht über eine Buntheit C_{ab}* ≥ 3, insbesondere C_{ab}* ≥ 4, aufweist, wobei der Parameter C_{ab}* im CIELab-Farbraum nach DIN 6174 festgelegt ist. Erfindungsgemäße photovoltaische Solarzellen verfügen auf der Seite der farbigen Metalloxidschicht vorzugsweise über eine Buntheit C_{ab}* ≥ 3.5, insbesondere C_{ab}* ≥ 4, wobei der Parameter C_{ab}* im CIELab-Farbraum nach DIN 6174 festgelegt ist. Erfindungsgemäße photovoltaische Solarmodule, insbesondere solche mit einer auf die farbgebende leitfähige Metalloxid-Frontelektrodenschicht auflaminierten transparenten Laminierfolie, z.B. EVA-Folie, verfügen auf der Seite der farbigen Metalloxidschicht vorzugsweise über eine Buntheit C_{ab}* ≥ 5, insbesondere C_{ab}* ≥ 6, wobei der Parameter C_{ab}* im CIELab-Farbraum nach DIN 6174 festgelegt ist. Interessanterweise wurde gefunden, dass durch die Laminierung der Metalloxid- bzw. Interferenzfilterschicht der erfindungsgemäßen Substrate der Farbton nochmals intensiver wird. Für die Messung in der Buntheit wird zweckmäßigerweise auf die Vorgaben der DIN 5033 zurückgegriffen. Für den Fall, dass die für diese Messung zu verwendende Ulbrichtkugel nicht direkt auf die zu vermessende Metalloxid- bzw. Interferenzfilterschicht aufgelegt werden kann, beispielsweise bei der Vermessung eines Solarmoduls, bei dem regelmäßig diese Metalloxid- bzw. Interferenzfilterschicht mit einer Laminierfolie und gegebenenfalls einer Deckglasschicht abgedeckt ist, hat die Referenzmessung an einem Weißstandard zu erfolgen, der in entsprechender Weise mit einer Laminierfolie und gegebenenfalls einer Deckglasschicht zu versehen ist.

Die der vorliegenden Erfindung zu Grunde liegende Aufgabe wird des Weiteren gelöst durch ein Array, umfassend mindestens zwei erfindungsgemäße Substrate, insbesondere in Form von Solarmodulen oder Solarzellen oder Bestandteilen hiervon. Dabei kann in einer Ausführungsform vorgesehen sein, dass dieses Array gekennzeichnet ist durch mindestens einen flächigen Träger, insbesondere eine Deckglasscheibe, auf der die Substrate, insbesondere Solarzellen oder Solarmodule, angebracht sind, vorzugsweise in der Weise, dass die farbige, lichtdurchlässige polykristalline Metalloxidschicht dem flächigen Träger zugewandt ist und/oder auf diesem, insbesondere haftend, aufliegt. Auf erfindungsgemäßen Arrays können mehrere erfindungsgemäße farbige Solarzellen oder Solarmodule aufgebracht werden, beispielsweise auf einer Träger- oder Deckglasscheibe. Hierdurch lässt sich ein gezielter Farb- bzw. Designeffekt auch für großflächige Formate erzielen. In einer zweckmäßigen Ausgestaltung können die erfindungsgemäßen Arrays als Fassaden oder Fassadenelemente oder -verkleidungen eingesetzt werden.

Der vorliegenden Erfindung lag die überraschende Erkenntnis zu Grunde, dass ohne zusätzliche Bauteile und Materialien farbige Bauteile zugänglich sind, beispielsweise Solarzellen bzw. -module, die sich durch einen sehr brillanten bzw. intensiven und sehr einheitlichen Farbeindruck auszeichnen. Der Erfindung lag ferner die überraschende Erkenntnis zugrunde, dass farbige Solarmodule und Solarzellen zugänglich sind, deren gewünschte Farbe bei der Herstellung gezielt einstellbar ist, und zwar ohne merkliche Wirkungsgradverluste in Kauf nehmen zu müssen. Erstaunlicherweise lassen sich mit den erfindungsgemäßen farbigen Solarmodulen die Wirkungsgrad- bzw. Leistungsverluste auf Werte unterhalb von 5%, vorzugsweise unterhalb von 2% und sogar unterhalb von 1% begrenzen. Als weiterer Vorteil hat sich erwiesen, dass nicht nur Solarmodule und Solarzellen mit einer Farbe ausgestattet werden können, sondern vielfältigste Substrate mit beschichteten oder beschichtbaren Oberflächen. Auch für größere Flächen werden mit dem erfindungsgemäßen Verfahren noch stets einheitliche, homogene Farbeindrücke erzielt. Hierbei hat sich als besonderer Vorteil erwiesen, dass bei Draufsicht sehr intensive Farbeindrücke erzielt werden, ohne hierfür auf eine zusätzliche Pigmentzugabe oder andere Farbstoffe angewiesen zu sein. Von weiterem Vorteil ist, dass die mit den erfindungsgemäßen Substraten erzielbaren Farbeindrücke in ihrer Qualität nur sehr geringfügig, wenn überhaupt, von dem Betrachtungswinkel in Bezug auf die Oberfläche Substrats abhängen.

Weitere Merkmale und Vorteile der Erfindung ergeben sich aus der nachgehenden Beschreibung, in der bevorzugte Ausführungsformen der Erfindung beispielhaft anhand schematischer Zeichnungen erläutert sind.

Dabei zeigen:
- Figur 1: ein Reflexionsspektrum eines erfindungsgemäßen Solarmoduls mit einer einen blauen Farbton generierenden Metalloxid-Frontelektrode,
- Figur 2: ein Reflexionsspektrum eines erfindungsgemäßen Solarmoduls mit einer einen grünen Farbton generierenden Metalloxid-Frontelektrode,
- Figur 3: ein Reflexionsspektrum eines erfindungsgemäßen Solarmoduls mit einer einen roten Farbton generierenden Metalloxid-Frontelektrode,
- Figur 4: eine schematische Darstellung einer Anordnung zur Farbmessung ohne Glanz- einschluss an einem farbigen Substrat nach DIN 5033, und
- Figur 5: eine schematische Darstellung einer Anordnung zur Farbmessung ohne Glanz- einschluss an einem farbigen Solarmodul in Anlehnung an DIN 5033.

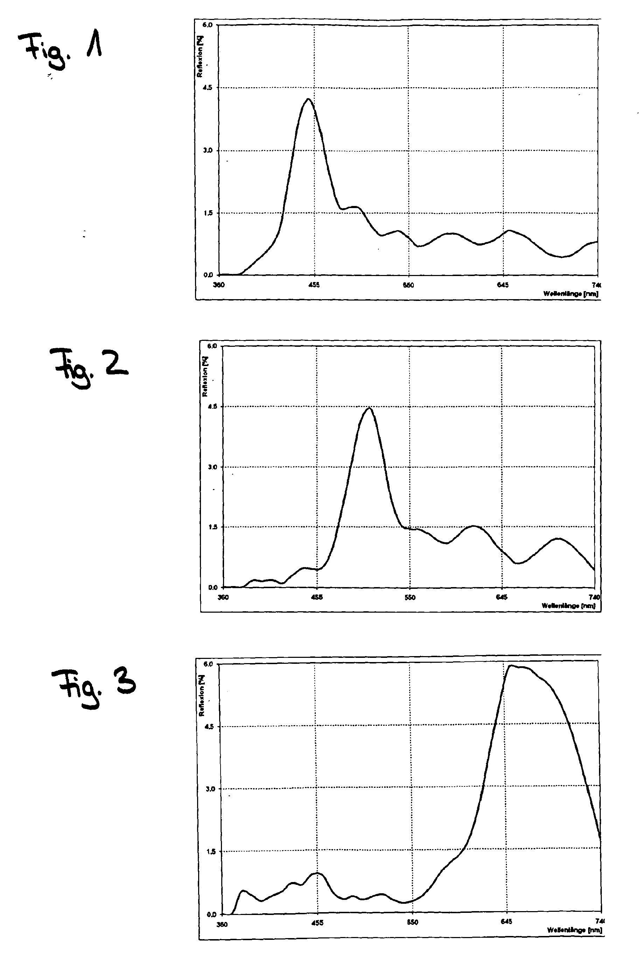

Figur 1 zeigt ein Reflexionsspektrum eines erfindungsgemäßen blauen Dünnschichtsolarmoduls, enthaltend eine Metalloxid-Frontelektrode, hergestellt nach dem erfindungsgemäßen Verfahren unter Verwendung einer Magnetron-Sputteranlage mit insgesamt vier Magnetrons, wobei jedes Magnetron über zwei Materialbeschichtungszonen verfügte. Als Sputtertarget wurde ein keramisches ZnO:Al₂O₃-Target eingesetzt, enthaltend etwa 2 Gew.-% Al₂O₃. Mit jeder Materialbeschichtungszone wurde eine Beschichtungslage mit einer durchschnittlichen Dicke von etwa 110 nm erhalten.

Figur 2 zeigt ein Reflexionsspektrum eines erfindungsgemäßen grünen Dünnschichtsolarmoduls, enthaltend eine Metalloxid-Frontelektrode, hergestellt nach dem erfindungsgemäßen Verfahren unter Verwendung einer Magnetron-Sputteranlage mit insgesamt vier Magnetrons, wobei jedes Magnetron zwei Materialbeschichtungszonen verfügte. Als Sputtertarget wurde ein keramisches ZnO:Al₂O₃-Target eingesetzt, enthaltend etwa 2 Gew.-% Al₂O₃. Mit jeder Materialbeschichtungszone wurde eine Beschichtungslage mit einer durchschnittlichen Dicke von etwa 130 nm erhalten.

Figur 3 zeigt ein Reflexionsspektrum eines erfindungsgemäßen roten Dünnschichtsolarmoduls, enthaltend eine Metalloxid-Frontelektrode, hergestellt nach dem erfindungsgemäßen Verfahren unter Verwendung einer Magnetron-Sputteranlage mit insgesamt vier Magnetrons, wobei jedes Magnetron zwei Materialbeschichtungszonen verfügte. Als Sputtertarget wurde ein keramisches ZnO:Al₂O₃-Target eingesetzt, enthaltend etwa 2 Gew.-% an Al₂O₃. Mit jeder Materialbeschichtungszone wurde eine Beschichtungslage mit einer durchschnittlichen Dicke von etwa 10 nm erhalten.

Die Reflexionsspektren wurden mit einem UV-VIS-NIR-Spektrometer gemessen.

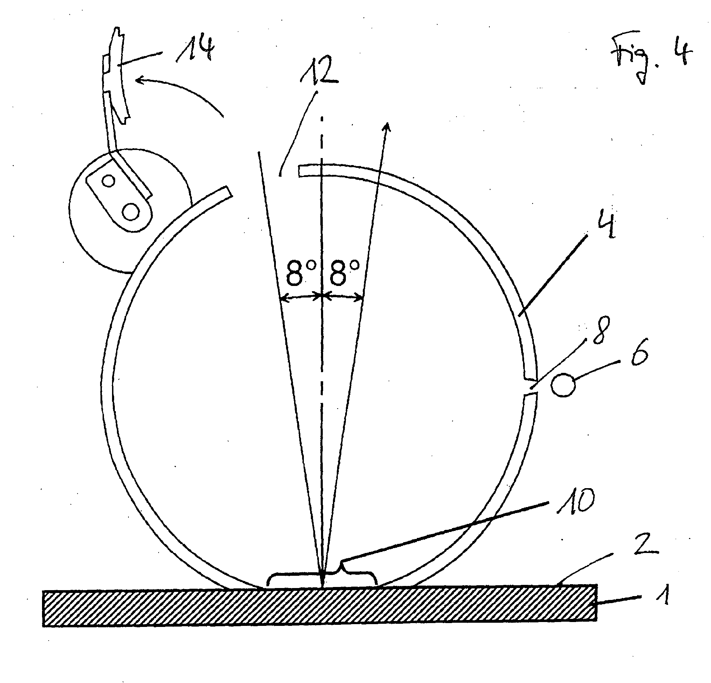

Figur 4 gibt eine schematische Darstellung einer Anordnung zur Farbmessung ohne Glanzeinschluss an einem farbigen erfindungsgemäßen Substrat nach DIN 5033 wieder. Auf der Metalloxidschicht 2 des erfindungsgemäßen Substrats 1 liegt die Ulbrichtkugel 4 auf. Über eine Lichtquelle 6, beispielsweise eine Xenon-Blitzlichtlampe, wird durch den Spalt 8 das Licht in die Ulbrichtkugel 4 eingeleitet und gelangt auf diese Weise auch auf den durch die Öffnung 10 freigelassenen Abschnitt der Metalloxidoberfläche 2. Die reflektierte Strahlung gelangt von dem zu vermessenden Probeabschnitt der Metalloxidschicht 2 über die Öffnung 12 zu dem Sensor 14.

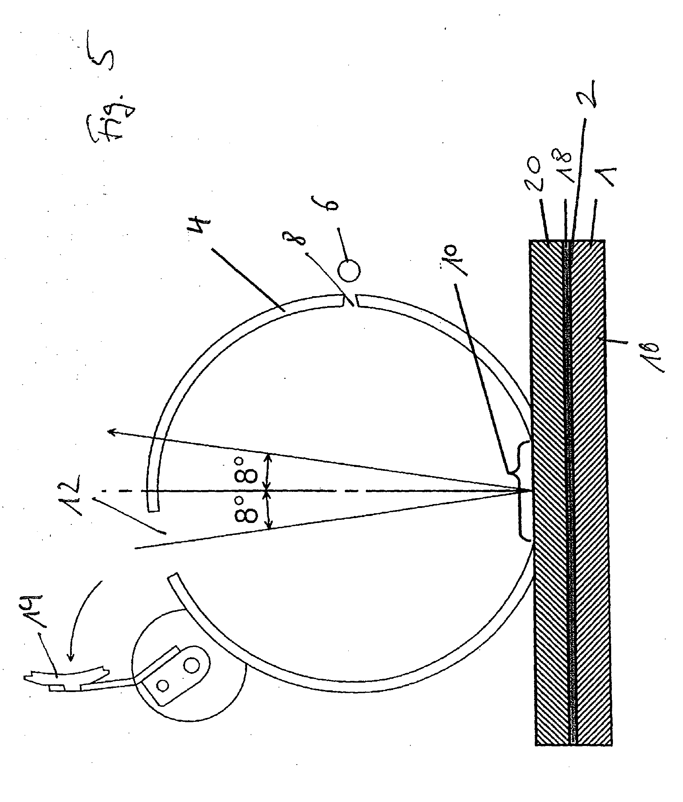

Figur 5 zeigt eine schematische Darstellung einer Anordnung zur Farbmessung ohne Glanzeinschluss an einem erfindungsgemäßen farbigen Solarmodul 16. Die Metalloxidschicht 2 liegt auf einem Substrat 1, beispielsweise in Form eines Systems aus intrinsischer Zinkoxidschicht und CIGSSe-Absorberschicht auf. Die Zinkoxidschicht 2 ist in der dargestellten Ausführungsform durch eine Laminierfolie 18, beispielsweise aus EVA, abgedeckt, woran sich die Deckglasscheibe 20 des Solarmoduls 16 anschließt. Bei der Vermessung von Solarmodulen liegt die Ulbrichtkugel demgemäß nicht unmittelbar auf der farbgenerierenden Metalloxidschicht 2 auf. In entsprechender Weise hat man für die Referenzmessung den Weißstandard ebenfalls mit der Laminierfolie 18 und dem Deckglas 20 zu versehen.

Die in der vorstehenden Beschreibung, in den Ansprüchen sowie in den Zeichnungen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Verfahren zur Herstellung eines Substrats mit einer farbigen Interferenzfilterschicht, enthaltend polykristallines Metalloxid oder polykristalline Metalloxide, durch physikalische oder chemische Gasphasenabscheidung mit einer Beschichtungsanlage, insbesondere mit Hilfe eines Sputtergases, bei dem man aus der Gasphase mindestens zwei, insbesondere mindestens sechs, Beschichtungslagen jeweils unter Ausbildung von polykristallinen Metalloxiden abscheidet mit einer durchschnittlichen Dicke der jeweiligen Beschichtungslagen im Bereich von etwa 50 nm bis 350 nm, insbesondere im Bereich von etwa 90 nm bis 210 nm, wobei die gemittelten atomaren Anteile mindestens eines, insbesondere jedes einzelnen, der in jeweils mindestens zwei, insbesondere sämtlichen, Beschichtungslagen, enthaltenen Metalle um nicht mehr als +/-20 Atom-%, vorzugsweise um nicht mehr als +/-10 Atom-% und besonders bevorzugt um nicht mehr als +/-5 Atom-%, von der gemittelten Zusammensetzung der Interferenzfilterschicht abweichen, wobei 100 Atom-% die Summe aller in der Schicht enthaltenen Metalle bezeichnet.

2. Verfahren zur Herstellung eines Substrats mit einer farbigen Interferenzfilterschicht, enthaltend polykristallines Metalloxid oder polykristalline Metalloxide, durch physikalische und/oder chemische Gasphasenabscheidung, insbesondere mit Hilfe eines Sputtergases, insbesondere nach Anspruch 1, umfassend die Schritte
a1) Zurverfügungstellung mindestens einer ersten Beschichtungsanlage zur, insbesondere physikalischen, Gasphasenabscheidung, enthaltend mindestens eine Beschichtungsquelle A, ausstattbar mit oder enthaltend physikalisch verdampfbares oder zerstäubbares Metall- oder Metalloxidmaterial, insbesondere ein Metall- oder Metalloxid-Sputtertarget, mit mindestens einer ersten Materialbeschichtungszone, insbesondere einer Sputter-Erosionszone, und mindestens einer zweiten Materialbeschichtungszone, insbesondere einer Sputter-Erosionszone, sowie gegebenenfalls mindestens einer r-ten Materialbeschichtungszone, insbesondere einer Sputter-Erosionszone, wobei r eine natürliche Zahl größer 2 ist, die zumindest abschnittsweise voneinander beabstandet nebeneinander entlang einer ersten Erstreckungsrichtung der Beschichtungsquelle A, insbesondere im Wesentlichen parallel, verlaufen,
b1) Zurverfügungstellung mindestens eines Substrats mit einer beschichtbaren bzw. beschichteten Oberfläche,
c1) Vorbeiführen der beschichtbaren bzw. beschichteten Oberfläche des Substrats, insbesondere in einem im Wesentlichen konstanten Abstand KA1 und/oder mit einer im Wesentlichen konstanten Geschwindigkeit VA1, an der ersten Beschichtungsquelle A unter Abscheidung von polykristallinem Metalloxid in der Weise, dass auf der beschichtbaren bzw. beschichteten Oberfläche zunächst erstes Material abgeschieden wird, das seinen Ursprung in der ersten Materialbeschichtungszone der ersten Beschichtungsquelle A hat, resultierend in einer ersten Beschichtungslage, dass auf dieses erste Material zweites Material abgeschieden wird, das seinen Ursprung in der zweiten Materialbeschichtungszone der ersten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der ersten Beschichtungsquelle A hat, resultierend in einer r-ten Beschichtungslage, und dass nach dem Vorbeifahren an der ersten Beschichtungsquelle A ein erster Schichtauftrag A1 aus zwei bzw. r Beschichtungslagen erhalten wird, wobei die durchschnittlichen Dicken der jeweiligen Beschichtungslagen auf einen Bereich von etwa 50 nm bis 350 nm, insbesondere von etwa 90 nm bis 210 nm, eingestellt werden,
c2) gegebenenfalls ein- oder mehrmaliges Vorbeiführen der gemäß Schritt c1) erhaltenen beschichteten Substratoberfläche, insbesondere in einem im Wesentlichen konstanten Abstand KA2 und/oder mit einer im Wesentlichen konstanten Geschwindigkeit VA2, an der zweiten Beschichtungsquelle A oder der ersten Beschichtungsquelle A unter Abscheidung von polykristallinem Metalloxid in der Weise, dass auf dem Schichtauftrag gemäß Schritt c1) erstes Material abgeschieden wird, das seinen Ursprung in der ersten Materialbeschichtungszone der zweiten Beschichtungsquelle A oder der ersten oder zweiten Materialbeschichtungszone der ersten Beschichtungsquelle A hat, resultierend in einer ersten Beschichtungslage, dass auf dieses erste Material zweites Material abgeschieden wird, das seinen Ursprung in der zweiten Materialbeschichtungszone der zweiten Beschichtungsquelle A oder der ersten bzw. zweiten Materialbeschichtungszone der ersten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der zweiten Beschichtungsquelle A oder der ersten Beschichtungsquelle A hat, resultierend in einer r-ten Beschichtungslage, und dass nach dem Vorbeifahren an der zweiten Beschichtungsquelle A oder der ersten Beschichtungsquelle A ein zweiter Schichtauftrag A2 aus zwei bzw. r Beschichtungslagen erhalten wird, wobei die durchschnittlichen Dicken der jeweiligen Beschichtungslagen auf einen Bereich von etwa 50 nm bis 350 nm, insbesondere von etwa 90 nm bis 210 nm, eingestellt werden,
cn) gegebenenfalls ein- oder mehrmaliges Vorbeiführen der gemäß Schritt c2) oder einem nachfolgenden Schritt cn) erhaltenen beschichteten Substratoberfläche, insbesondere in einem im Wesentlichen konstanten Abstand KAn und/oder mit einer im Wesentlichen konstanten Geschwindigkeit VAn, an der dritten bzw. (n+1)-ten Beschichtungsquelle A oder an der ersten und/oder zweiten Beschichtungsquelle A unter Abscheidung von polykristallinem Metalloxid in der Weise, dass auf dem Schichtauftrag gemäß Schritt c2) bzw. Schritt cn)
zunächst erstes Material abgeschieden wird, das seinen Ursprung in der ersten Materialbeschichtungszone der n-ten Beschichtungsquelle A hat, resultierend in einer ersten Beschichtungslage, dass auf dieses erste Material zweites Material abgeschieden wird, das seinen Ursprung in der zweiten Materialbeschichtungszone der n-ten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der ersten, zweiten oder n-ten Beschichtungsquelle A hat, resultierend in einer r-ten Beschichtungslage, oder dass
ein erstes Material abgeschieden wird, das seinen Ursprung in der ersten oder zweiten Materialbeschichtungszone der ersten oder zweiten Beschichtungsquelle A hat, resultierend in einer ersten Beschichtungslage, dass auf dieses erste Material zweites Material abgeschieden wird, das seinen Ursprung in der zweiten bzw. ersten Materialbeschichtungszone der ersten oder zweiten Beschichtungsquelle A hat, resultierend in einer zweiten Beschichtungslage, dass gegebenenfalls auf dieses zweite Material bzw. auf das jeweilige Vorgängermaterial r-tes Material abgeschieden wird, das seinen Ursprung in der r-ten Materialbeschichtungszone der ersten oder zweiten Beschichtungsquelle A hat, resultierend in einer r-ten Beschichtungslage, und dass nach dem Vorbeifahren an der ersten, zweiten bzw. n-ten Bedampfungsquelle A ein n-ter Schichtauftrag An aus zwei bzw. r Beschichtungslagen erhalten wird, wobei die durchschnittlichen Dicken der jeweiligen Beschichtungslagen auf einen Bereich von etwa 50 nm bis 350 nm, insbesondere von etwa 90 nm bis 210 nm, eingestellt werden,
wobei n eine natürliche Zahl größer 2 ist, wobei die 1, 2 oder n Beschichtungsquellen A nebeneinander entlang der Fahrstrecke des Substrats angeordnet oder anordbar sind und wobei die 2 oder r Materialbeschichtungszonen beabstandet nebeneinander angeordnet sind, und wobei durch die 1, 2 oder n Beschichtungsquellen A, an denen die beschichtbare bzw. beschichtete Oberfläche des Substrats jeweils zwecks physikalischer Abscheidung aus der Gasphase jeweils ein- oder mehrmals vorbeigeführt wird, eine Interferenzfilterschicht mit einer durchschnittlichen Dicke DIF im Bereich von etwa 180 nm bis 10.000 nm, insbesondere im Bereich von etwa 250 nm bis 2.500 nm, erhalten wird;
wobei die Bewegungsrichtung des Substrats mit der beschichtbaren bzw. beschichteten Oberfläche und die erste Erstreckungsrichtung in einem Winkel zueinander ausgerichtet sind und insbesondere einen im Wesentlichen rechten Winkel bilden,
oder umfassend die Schritte
x1) Zurverfügungstellung mindestens einer zweiten Beschichtungsanlage zur physikalischen oder chemischen Gasphasenabscheidung, enthaltend mindestens zwei Beschichtungsquellen B, ausstattbar mit oder enthaltend verdampfbares Metall- oder Metalloxidmaterial oder eine verdampfbare und zersetzbare metallorganische Verbindung, mit einer dritten, insbesondere entlang einer ersten Erstreckungsrichtung der Beschichtungsquelle B verlaufenden, Materialbeschichtungszone,
y1) Zurverfügungstellung mindestens eines Substrats mit einer beschichtbaren bzw. beschichteten Oberfläche,
z1) Vorbeiführen der beschichtbaren bzw. beschichteten Oberfläche eines Substrats, insbesondere in einem im Wesentlichen konstanten Abstand KA1 und/oder mit einer im Wesentlichen konstanten Geschwindigkeit VA1, an der ersten Beschichtungsquelle B unter Abscheidung von polykristallinem Metalloxid in der Weise, dass auf der beschichtbaren bzw. beschichteten Oberfläche Material abgeschieden wird, das seinen Ursprung in der ersten Beschichtungsquelle B hat, und dass nach dem Vorbeifahren an der ersten Beschichtungsquelle B eine erste Beschichtungslage B1 mit einer durchschnittlichen Dicke K1 im Bereich von etwa 50 nm bis 350 nm, insbesondere im Bereich von etwa 90 nm bis 210 nm, erhalten wird, und
z2) ein- oder mehrmaliges Vorbeiführen der gemäß Schritt z1) erhaltenen beschichteten Substratoberfläche, insbesondere in einem im Wesentlichen konstanten Abstand KA2 und/oder mit einer im Wesentlichen konstanten Geschwindigkeit VA2, an der zweiten Beschichtungsquelle B oder an der ersten Beschichtungsquelle B unter Abscheidung von polykristallinem Metalloxid in der Weise, dass auf der Beschichtungslage gemäß Schritt z1) Material abgeschieden wird, das seinen Ursprung in der zweiten Beschichtungsquelle B bzw. der ersten Beschichtungsquelle B hat, und dass nach dem Vorbeifahren an der zweiten Beschichtungsquelle B oder der ersten Beschichtungsquelle B eine zweite Beschichtungslage B2 mit einer durchschnittlichen Dicke K2 im Bereich von etwa 50 nm bis 350 nm, insbesondere im Bereich von etwa 90 nm bis 210 nm, erhalten wird,
zm) gegebenenfalls ein- oder mehrmaliges Vorbeiführen der gemäß Schritt z2) oder einem nachfolgenden Schritt zm) erhaltenen beschichteten Substratoberfläche, insbesondere in einem im Wesentlichen konstanten Abstand KAm und/oder mit einer im Wesentlichen konstanten Geschwindigkeit VAm, an der m-ten Beschichtungsquelle B unter Abscheidung von polykristallinem Metalloxid in der Weise,
dass auf der Beschichtungslage gemäß Schritt z2) bzw. Schritt zm) Material abgeschieden wird, das seinen Ursprung in der dritten bzw. (m+1)-ten Beschichtungsquelle B hat, an der m-ten Beschichtungsquelle B unter Abscheidung von polykristallinem Metalloxid in der Weise,
oder dass auf der Beschichtungslage gemäß Schritt z2) bzw. Schritt zm) Material abgeschieden wird, das seinen Ursprung in der ersten oder zweiten Beschichtungsquelle B hat,
und dass nach dem Vorbeifahren an der m-ten Beschichtungsquelle B oder an der ersten und/oder zweiten Beschichtungsquelle B eine m-te Beschichtungslage Bm mit einer durchschnittlichen Dicke Km im Bereich von etwa 50 nm bis 350 nm, insbesondere im Bereich von etwa 90 nm bis 210 nm, erhalten wird,
wobei m eine natürliche Zahl größer 2 ist, wobei die 1, 2 oder m Beschichtungsquellen B nebeneinander entlang der Fahrstrecke des Substrats angeordnet oder anordbar sind und wobei durch die 1, 2 oder m Beschichtungsquellen, an denen die beschichtbare bzw. beschichtete Oberfläche des Substrats jeweils zwecks physikalischer oder chemischer Abscheidung aus der Gasphase jeweils ein- oder mehrmals vorbeigeführt wird, eine Interferenzfilterschicht mit einer durchschnittlichen Dicke DIF im Bereich von etwa 180 nm bis 10.000 nm, insbesondere im Bereich von etwa 250 nm bis 2.500 nm, erhalten wird, und
wobei gegebenenfalls die Bewegungsrichtung des Substrats mit der beschichtbaren bzw. beschichteten Oberfläche und die erste Erstreckungsrichtung in einem Winkel zueinander ausgerichtet sind und insbesondere einen im Wesentlichen rechten Winkel bilden; und
wobei die gemittelten atomaren Anteile mindestens eines, insbesondere jedes einzelnen, der in jeweils mindestens zwei, insbesondere sämtlichen, Beschichtungslagen, enthaltenen Metalle um nicht mehr als +/-20 Atom-%, vorzugsweise um nicht mehr als +/-10 Atom-% und besonders bevorzugt um nicht mehr als +/-5 Atom- %, von der gemittelten Zusammensetzung der Interferenzfilterschicht abweichen, wobei 100 Atom-% die Summe aller in der Schicht enthaltenen Metalle bezeichnet.

3. Verfahren nach Anspruch 1 oder 2, **dadurch gekennzeichnet, dass** die Beschichtungsanlage zur, insbesondere physikalischen, Gasphasenabscheidung eine Magnetron-Sputteranlage umfasst und dass die Beschichtungsquelle ein Magnetron umfasst bzw. darstellt mit einer Vorder- und einer Rückseite sowie mit einer Längs- und einer Quererstreckung, enthaltend mindestens ein Magnetsystem hinter oder benachbart zur Oberseite, das beabstandet voneinander außenliegende und mindestens einen innenliegenden Permanentmagneten in Nord-Süd-Nord- oder Süd-Nord-Süd-Anordnung umfasst, vorzugsweise ausgerichtet und angeordnet entlang der ersten Erstreckungsrichtung des Magnetrons.

4. Verfahren nach einem der vorangehenden Ansprüche, **dadurch gekennzeichnet, dass** je ein, insbesondere planares, Metall- oder Metalloxidtarget, insbesondere Rechtecktarget, auf der Vorderseite des Magnetrons angeordnet ist, so dass das Magnetsystem zumindest bereichsweise, insbesondere vollständig, abgedeckt wird.

5. Verfahren nach Anspruch 1 oder 2, **dadurch gekennzeichnet, dass** die Beschichtungsanlage zur physikalischen Gasphasenabscheidung eine Magnetronsputtereinrichtung umfasst, welche ein um eine axiale Längsachse drehbar gelagertes zylindrisches Rohrtarget umfasst mit einem im Inneren des Rohrtargets angeordneten Magnetsystem.

6. Verfahren nach einem der vorangehenden Ansprüche, **dadurch gekennzeichnet, dass** die Interferenzfilterschicht insgesamt mindestens zwei, vorzugsweise mindestens sechs, Beschichtungslagen umfasst.

7. Verfahren nach einem der vorangehenden Ansprüche, **dadurch gekennzeichnet, dass** das Substrat eine Solarzelle oder ein Solarmodul oder einen Bestandteil hiervon und/oder dass die farbige Interferenzfilterschicht eine leitfähige lichtdurchlässige Elektrodenschicht oder Frontelektrodenschicht, insbesondere einer Solarzelle bzw. eines Solarmoduls, darstellt.

8. Verfahren nach einem der vorangehenden Ansprüche, **dadurch gekennzeichnet, dass** die durchschnittlichen Dicken des ersten, zweiten und/oder n-ten Schichtauftrags oder mindestens zweier, insbesondere sämtlicher, Beschichtungslagen im Wesentlichen übereinstimmen und/oder in den Grenzen +/- 20 %, vorzugsweise +/- 10 %, besonders bevorzugt +/- 5 %, variieren.

9. Verfahren nach einem der vorangehenden Ansprüche, **dadurch gekennzeichnet, dass** das Metalloxid Zinkoxid oder ein mit, insbesondere bis zu etwa 5 Gew.-% an, Aluminium oder Aluminiumoxid, Bor oder Boroxid, Gallium oder Galliumoxid und/oder Indium oder Indiumoxid angereichertes Zinkoxid darstellt bzw. umfasst.

10. Verfahren nach einem der vorangehenden Ansprüche, **dadurch gekennzeichnet, dass** der erste, zweite, oder n-te Schichtauftrag zwei Beschichtungslagen umfasst, die jeweils auf eine Materialbeschichtungszone zurückgehen.

11. Verfahren nach einem der vorangehenden Ansprüche, **dadurch gekennzeichnet, dass** mindestens eines, insbesondere jedes einzelne, der in der Interferenzfilterschicht enthaltenen Metalle tiefenaufgelöst über das gesamte Volumen derselben um nicht mehr als +/-20 Atom-%, insbesondere um nicht mehr als +/-10 Atom-%, besonders bevorzugt nicht mehr als +/-5 Atom-%, von der gemittelten Zusammensetzung der Metalle in dieser Interferenzfilterschicht abweicht, wobei 100 Atom-% die Summe aller in der Schicht enthaltenen Metalle bezeichnet.

12. Verfahren nach einem der vorangehenden Ansprüche, **dadurch gekennzeichnet, dass** die Metalloxide in der Weise abgeschieden werden, dass die atomaren Anteile mindestens eines, insbesondere jedes einzelnen der in dem ersten, zweiten, und/oder n-ten Schichtauftrag und/oder in mindestens einer, insbesondere sämtlichen, Beschichtungslagen enthaltenen Metalle jeweils im Wesentlichen übereinstimmen.

13. Verfahren nach einem der vorangehenden Ansprüche, **dadurch gekennzeichnet, dass** man als Sputtergas ein Inertgas oder ein Inertgasgemisch, insbesondere Argon bzw. umfassend Argon, verwendet oder dass man als Sputtergas ein Inertgas oder ein Inertgasgemisch, insbesondere Argon bzw. umfassend Argon, verwendet, das einen Volumenanteil an Sauerstoff enthält, der insbesondere derart eingestellt wird, dass das Metalloxid unterstöchiometrisch bezüglich Sauerstoff, gemittelt über das Volumen des ersten, zweiten, m-ten und/oder n-ten Materialauftrags, in dem ersten, zweiten, m-ten bzw. n-ten Materialauftrag vorliegt.

14. Verfahren nach einem der vorangehenden Ansprüche, **dadurch gekennzeichnet, dass** die durchschnittliche Dicke der ersten, zweiten und n-ten Schichtaufträge und/oder mindestens zweier, insbesondere sämtlicher, Beschichtungslagen derart gewählt wird, dass sich bei Einstrahlung von sichtbarem Licht durch lichtoptische Interferenz ein schmalbandiges Reflexionsbandpassfilter ausbildet, das im Wellenlängenbereich von 360 nm bis 860 nm eine auf die Wellenlänge des Reflexionsmaximums bezogene Halbwertsbreite von maximal 35%, insbesondere maximal 25%, aufweist.

15. Verfahren nach einem der vorangehenden Ansprüche, **dadurch gekennzeichnet, dass** Substrat mit der beschichtbaren oder beschichteten Oberfläche zwecks Gasphasenabscheidung an der bzw. den Beschichtungsquellen, insbesondere jeweils enthaltend mindestens zwei Materialbeschichtungszonen, in im Wesentlichen gleichen Abstand und mit im Wesentlichen gleicher Geschwindigkeit vorbeigeführt wird.

16. Verfahren nach einem der Ansprüche 7 bis 15, **dadurch gekennzeichnet, dass** die Solarzelle bzw. das Solarmodul, vorzugsweise in dieser Abfolge, eine elektrisch leitfähige Rückelektrodenschicht, eine lichtumwandelnde Absorberschicht, insbesondere auf der Basis eines III-V-Halbleiters oder eines II-VI-Halbleiters oder eines I-III-VI-Halbleiters oder eines organischen Halbleiters, und die Interferenzfilterschicht sowie gegebenenfalls mindestens eine Laminierfolie und/oder eine Deckglasscheibe umfasst.

17. Verfahren nach einem der vorangehenden Ansprüche, **dadurch gekennzeichnet, dass** die Brechzahlen der Beschichtungslagen sowie der ersten und zweiten Übergänge und/oder dass die durchschnittliche Brechzahl der Metalloxidschicht bei einer Wellenlänge von 590 nm eingestellt werden auf einen Wert im Bereich von 1,2 bis 3,6, insbesondere im Bereich von 1,7 bis 2,5, vorzugsweise oberhalb von 1,95, und besonders bevorzugt im Bereich von 2,0 oder 2,1 bis 2,5.

18. Substrat, enthaltend eine farbige, lichtdurchlässige polykristalline Metalloxidschicht, erhalten durch physikalische oder chemische Gasphasenabscheidung, insbesondere erhältlich nach einem Verfahren gemäß einem der vorangehenden Ansprüche, als Interferenzfilterschicht, umfassend mindestens zwei, insbesondere mindestens sechs, Beschichtungslagen, **dadurch gekennzeichnet, dass** die gemittelten atomaren Anteile mindestens eines, insbesondere jedes einzelnen, der in jeweils mindestens zwei, insbesondere sämtlichen, Beschichtungslagen, enthaltenen Metalle um nicht mehr als +/-20 Atom-%, vorzugsweise um nicht mehr als +/-10 Atom-% und besonders bevorzugt um nicht mehr als +/-5 Atom-%, von der gemittelten Zusammensetzung der Metalloxidschicht abweichen, wobei 100 Atom-% die Summe aller in der Schicht enthaltenen Metalle bezeichnet, und dass die durchschnittlichen Dicken der Beschichtungslagen im Bereich von etwa 50 nm bis 350 nm, insbesondere im Bereich von etwa 90 nm bis 210 nm, liegen.

19. Substrat nach Anspruch 18, **dadurch gekennzeichnet, dass** mindestens eines, insbesondere jedes einzelne, der in der Metalloxidschicht enthaltenen Metalle tiefenaufgelöst über das gesamte Volumen derselben um nicht mehr als +/- 20 Atom-%, insbesondere um nicht mehr als +/-10 Atom-%, besonders bevorzugt um nicht mehr als +/- 5 Atom-%, von der gemittelten Zusammensetzung der Metalle in dieser Metalloxidschicht abweicht, wobei 100 Atom-% die Summe aller in der Schicht enthaltenen Metalle bezeichnet.

20. Substrat nach Anspruch 18 oder 19, **dadurch gekennzeichnet, dass** die atomaren Anteile mindestens eines, insbesondere jedes einzelnen, der in den Beschichtungslagen enthaltenen Metalle jeweils im Wesentlichen übereinstimmen und/oder dass durchschnittliche Dicken mindestens zweier, insbesondere sämtlicher, Beschichtungslagen im Wesentlichen übereinstimmen und/oder maximal in den Grenzen +/- 20 %, vorzugsweise +/- 5 %, besonders bevorzugt +/- 2 %, variieren.

21. Substrat nach einem der Ansprüche 18 bis 20, **dadurch gekennzeichnet, dass** in einem ersten bzw. in ersten Übergangen zwischen, insbesondere sämtlichen einander, benachbarten Lagen, insbesondere Beschichtungslagen, insbesondere in einer Ebene parallel zur Oberfläche des Substrats, eine, insbesondere flächenhafte, Störung des Kristallgefüges vorliegt, mit der eine Brechzahl einhergeht, die sich von der Brechzahl der jeweils benachbarten Kristallgefüge der Lagen, insbesondere Beschichtungslagen, unterscheidet, und/oder dass das polykristalline Metalloxid in Säulenform aufwächst mit der Hauptausrichtung der Säulen in einem Winkel zur Substratoberfläche, insbesondere im Wesentlichen +/-45°, insbesondere +/-15°, gegen die Normalenrichtung der Substratoberfläche, wobei in einem zweiten bzw. in zweiten Übergängen zwischen benachbarten Säulen eine, insbesondere flächenhafte, Störung des Kristallgefüges vorliegt, mit der eine Brechzahl einhergeht, die sich von der Brechzahl der jeweils benachbarten Kristallgefüge in den Säulen unterscheidet.

22. Substrat nach einem der Ansprüche 18 bis 21, **dadurch gekennzeichnet, dass** die flächenhaften Störungen des Kristallgefüges in den zweiten Übergängen benachbarter Säulen zumindest in einer Ebene normal zur Substratoberfläche sichelförmig verformt sind.

23. Substrat nach einem der Ansprüche 18 bis 22, **dadurch gekennzeichnet, dass** in dem oder den ersten Übergängen und/oder in dem oder den zweiten Übergängen eine Anreicherung an Aluminium, Bor, Gallium und/oder Indium oder deren Oxiden gegeben ist und/oder das Metalloxid, insbesondere Zinkoxid, unterstöchiometrisch in Bezug auf Sauerstoff vorliegt.

24. Substrat nach einem der Ansprüche 18 bis 23, **dadurch gekennzeichnet, dass** die Brechzahlen der Beschichtungslagen sowie der ersten und zweiten Übergänge und/oder dass die durchschnittliche Brechzahl der Metalloxidschicht bei einer Wellenlänge von 590 nm im Bereich von 1,2 bis 3,6, insbesondere im Bereich von 1,7 bis 2,5, vorzugsweise oberhalb von 1,95, und besonders bevorzugt im Bereich von 2,0 oder 2,1 bis 2,5, liegen.

25. Substrat nach einem der Ansprüche 18 bis 24, **dadurch gekennzeichnet, dass** farbige, lichtdurchlässige polykristalline Metalloxidschicht elektrisch leitend ist, insbesondere einen spezifischen elektrischen Widerstand aufweist im Bereich von 0 bis 1 Ohm-Meter, vorzugsweise im Bereich von 1 x 10⁻⁷ Ohm-Meter bis 1 x 10⁻³ Ohm-Meter, besonders bevorzugt im Bereich von 2 x 10⁻⁵ Ohm-Meter bis 2 x 10⁻⁴ Ohm-Meter.

26. Substrat nach Anspruch 25, **dadurch gekennzeichnet, dass** dieses eine Solarzelle oder ein Solarmodul oder einen Bestandteil hiervon und dass die farbige, lichtdurchlässige polykristalline Metalloxidschicht eine Interferenzfilterschicht und gleichzeitig eine Elektrodenschicht, insbesondere Frontelektrodenschicht, darstellt.

27. Substrat nach einem der Ansprüche 18 bis 26, **dadurch gekennzeichnet, dass** die Metalloxidschicht eine durchschnittliche Dicke im Bereich von 0,18 µm bis 10 µm, bevorzugt im Bereich von 0,25 µm bis 2,5 µm, aufweist.

28. Substrat nach einem der Ansprüche 18 bis 27, **dadurch gekennzeichnet, dass** die lateralen Abweichungen der Dicke der Beschichtungslagen maximal in den Grenzen +/- 10 %, vorzugsweise +/- 5%, und besonders bevorzugt +/- 2%, variieren.

29. Substrat nach einem der Ansprüche 18 bis 28, **dadurch gekennzeichnet, dass** die Metalloxidschicht auf Zinkoxid oder auf Zinkoxid und, insbesondere nicht mehr als 5 Gew.-% an, Aluminium oder Aluminiumoxid, Bor oder Boroxid, Gallium oder Galliumoxid und/oder Indium oder Indiumoxid basiert.

30. Substrat nach einem der Ansprüche 18 bis 29, **dadurch gekennzeichnet, dass** das Metalloxid, insbesondere Zinkoxid, in der Metalloxidschicht, gemittelt über das Volumen dieser Metalloxidschicht, unterstöchiometrisch bezüglich Sauerstoff vorliegt.

31. Substrat nach einem der Ansprüche 26 bis 30, **dadurch gekennzeichnet, dass** die Solarzelle bzw. das Solarmodul, vorzugsweise in dieser Abfolge, eine elektrisch leitfähige Rückelektrodenschicht, eine lichtumwandelnde Absorberschicht, insbesondere auf der Basis eines III-V-Halbleiters oder eines II-VI-Halbleiters oder eines I-III-VI-Halbleiters oder eines organischen Halbleiters, und die Frontelektrodenschicht sowie gegebenenfalls eine Laminierfolie und/oder eine Deckglasscheibe umfasst.

32. Substrat nach einem der Ansprüche 18 bis 31, **dadurch gekennzeichnet, dass** dieses auf der Seite der farbigen Metalloxidschicht eine Buntheit C_{ab}* ≥ 3, insbesondere C_{ab}* ≥4, aufweist, wobei der Parameter C_{ab}* im CIELab-Farbraum nach DIN 6174 festgelegt ist.

33. Substrat nach Anspruch 32, **dadurch gekennzeichnet, dass** dieses eine photovoltaische Solarzelle darstellt und dass diese auf der Seite der farbigen Metalloxidschicht eine Buntheit C"_{b}* ≥ 3.5, insbesondere C_{ab}* ≥ 4, aufweist, wobei der Parameter C_{ab}* im CIELab-Farbraum nach DIN 6174 festgelegt ist, oder dieses eine photovoltaisches Solarmodul darstellt und dass dieses auf der Seite der farbigen Metalloxidschicht eine Buntheit C_{ab}* ≥ 5, insbesondere C_{ab}* ≥ 6, aufweist, wobei der Parameter C_{ab}* im CIELab-Farbraum nach DIN 6174 festgelegt ist.

34. Verwendung des Substrats nach einem der Ansprüche 18 bis 33 als farbige Solarzelle oder als farbiges Solarmodul oder als Bestandteil hiervon.

35. Array, insbesondere Fassadenverkleidung oder Bestandteil hiervon, umfassend mindestens zwei Substrate nach einem der Ansprüche 18 bis 33, insbesondere nach einem der Ansprüche 26 bis 33.

36. Array nach Anspruch 35, **gekennzeichnet durch** mindestens einen flächigen Träger, insbesondere eine Deckglasscheibe, auf der die Substrate, insbesondere Solarzellen oder Solarmodule, angebracht sind, vorzugsweise in der Weise, dass die farbige, lichtdurchlässige polykristalline Metalloxidschicht dem flächigen Träger zugewandt ist und/oder auf diesem, insbesondere haftend, aufliegt.
